# EUROPEAN PATENT SPECIFICATION

(11) **EP 4 354 380 B1**
(45) Date of publication and mention of the grant of the patent: **22.10.2025**
(21) Application number: 22820343.6
(22) Date of filing: 10.06.2022
(51) Int. Cl.: G06Q 50/08, G06F 30/13, G06F 30/20, G06T 17/00, G06T 19/20

(54) **CONSTRUCTION ACCEPTANCE INSPECTION METHOD, DEVICE, AND SYSTEM**
VERFAHREN, VORRICHTUNG UND SYSTEM ZUR INSPEKTION VON BAUAKZEPTANZEN
PROCÉDÉ, DISPOSITIF ET SYSTÈME D'INSPECTION DE RÉCEPTION DE CONSTRUCTION

(30) Priority: 10.06.2021 CN 202110650860
(43) Date of publication of application: 17.04.2024
(73) Proprietor: Daikin Industries, Ltd., Osaka-shi, Osaka 530-0001 (JP)
(72) Inventor: WANG, Qi, Osaka-shi, Osaka 530-0001 (JP); JIANG, Lan, Osaka-shi, Osaka 530-0001 (JP); GAN, Quan, Osaka-shi, Osaka 530-0001 (JP)
(74) Representative: Conti, Marco
(86) International application number: PCT/JP2022/023473
(87) International publication number: WO 2022/260165

(56) References cited:
- CN-A- 112 347 540
- CN-A- 112 733 240
- DE-A1- 102019 208 918
- JP-A- 2005 327 170
- JP-A- 2018 124 843
- JP-A- 2018 124 843
- JP-A- 2020 095 009
- JP-A- 2020 101 573
- US-A1- 2020 005 447
- "Forefront of i-Construction", 21 June 2019, RIKO TOSHO CO., LTD., JP, ISBN: 978-4-8446-0887-5, article SHINYA SUGIURA: "State-of-the-art ICT construction and inspection technology utilizing new tools such as drones", pages: 89 - 111, XP009541846

## Description

### TECHNICAL FIELD

The present invention relates to a construction technical field and, in particular, to a construction inspection method, apparatus, and system.

### BACKGROUND ART

With the development of urbanization and the improvement of modernization, various constructions have become huge in size and complicated, but the traceability of construction quality management with the low level of computerization has always become a shortboard of the industry. Further, for the inspection of constructions, manual inspection is usually performed, but its efficiency is low, and execution of unified standards is also not possible. In addition, when a typical operation is performed on the concealed construction during the construction, it is almost impossible to accurately determine the construction quality, and the inspection operation is inconvenient, and therefore, the construction period of the construction becomes long, and the construction quality cannot be secured.

In recent years, a technique of using a virtual building construction three-dimensional model for supporting construction quality management has appeared.

It should be noted that the introduction of the above technical background is merely provided to facilitate the understanding of those skilled in the art while helping to provide clearer and more complete descriptions of the technical solutions of the present invention. These technical solutions are merely described in the background of the present invention and should not be construed as being publicly known to those skilled in the art.
An example of known construction inspection method, apparatus, and system is disclosed by patent document US2020005447A1.

### SUMMARY OF THE INVENTION

However, the inventor has found that the manual inspection method has low efficiency and poor accuracy, which cannot ensure the uniformity of the construction quality standard, and even when the building construction three-dimensional model is introduced, the inspection efficiency is still low due to its complicated processing process and its large calculation amount.

Aim of the present invention is to provide a construction inspection method, a construction inspection apparatus and a construction inspection system which improve the state of the art indicated above. This aim is achieved by the computer-implemented construction inspection method, apparatus and system according to the corresponding appended claims.

In order to solve at least one of the above problems, an embodiment of the present invention provides a construction inspection method, apparatus, and system, and at a construction site, a first construction model is established based on detection data at the site, the first construction model is compared with a previously established second construction model based on design data, and an inspection result is confirmed in accordance with a comparison result so that the model established based on the result actually detected at the site is compared with the design model, and therefore it is possible to accurately reflect the difference between the actually completed situation of the construction and the desired design plan, the inspection result may be highly accurate, and the inspection may also be performed according to a unified standard. In addition, as the two models are directly compared with each other, the processing process is simple, and the inspection efficiency is high. After the inspection result is acquired, the inspection result may be shared with the user. Thus, the user at a location other than the site may also acquire the inspection result in a timely manner, which improves the inspection efficiency, enhances the convenience of inspection, saves time and effort, and improves the user experience.

A first aspect of the embodiment of the present invention provides a computer-implemented construction inspection method including the steps defined in claim 1.

A second aspect of the embodiment of the present invention provides a construction inspection apparatus as defined by claim 19.

A third aspect of the embodiment of the present invention provides a construction inspection system, according to claim 20, including a terminal device that acquires detection data at a construction site, and the construction inspection apparatus according to the second aspect of the embodiment of the present invention that confirms an inspection result of a construction based on the detection data at the construction site and a previously established second construction model based on construction design data.

One of the advantages of the embodiment of the present invention is as follows. At the construction site, the first construction model is established based on the detection data at the site, the first construction model is compared with the previously established second construction model based on the design data, and the inspection result is confirmed in accordance with the comparison result so that the model established based on the result actually detected at the site is compared with the design model, and therefore it is possible to accurately reflect the difference between the actually completed situation of the construction and the desired design plan, the inspection result may be highly accurate, and the inspection may also be performed according to a unified standard. In addition, as the two models are directly compared with each other, the processing process is simple, and the inspection efficiency is high. After the inspection result is acquired, the inspection result may be shared with the user. Thus, the user at a location other than the site may also acquire the inspection result in a timely manner, which improves the inspection efficiency, enhances the convenience of inspection, saves time and effort, and improves the user experience.

With reference to the following description and drawings, specific embodiments of the present invention are disclosed in detail, and forms in which the principles of the present invention are adopted are also illustrated. It should be understood that the present invention may include changes, modifications, and equivalents within the scope of the appended claims.

It should be emphasized that the term "comprise/include" is used in this specification to indicate the presence of feature information, body components, steps, or members but does not preclude the presence or addition of one or more other feature information, body components, steps, or members.

### BRIEF DESCRIPTION OF THE DRAWINGS

Many aspects of the present invention may be better understood with reference to the following attached drawings. The members in the attached drawings are not illustrated for comparison, but merely illustrated to indicate the principles of the present invention. For the purpose of convenient representation and description of some parts according to the present invention, the parts corresponding to the accompanying drawings may be enlarged or reduced. The elements or feature information illustrated in one attached drawing or one embodiment according to the present invention may be combined with elements or feature information illustrated in one or more other attached drawings or embodiments. Moreover, in the attached drawings, similar reference numerals denote the corresponding members in some attached drawings and may denote the corresponding members used in more than one embodiment.

In the attached drawings,
Fig. 1 is a flow chart of a construction inspection method according to a first embodiment of the present invention.
Fig. 2 is a flow chart of a method for implementing Step 101 using a laser radar signal according to the first embodiment of the present invention.
Fig. 3 is a flow chart of a method for implementing Step 101 using an image signal according to the first embodiment of the present invention.
Fig. 4 is a schematic view of acquiring detection data by an AR device or an unmanned device according to the first embodiment of the present invention.
Fig. 5 is a flow chart of a method for implementing Step 101 using a ground penetrating radar signal according to the first embodiment of the present invention.
Fig. 6 is a schematic view of a method for model alignment according to the first embodiment of the present invention.
Fig. 7 is a schematic view of collisional verification between a first construction model and a second construction model according to the first embodiment of the present invention.
Fig. 8 is a schematic view of marking a component having a mismatch according to the first embodiment of the present invention.
Fig. 9 is a flow chart of a method for implementing Step 103 according to the first embodiment of the present invention.
Fig. 10 is a flow chart of a method for inspecting installation of an air conditioner according to the first embodiment of the present invention.
Fig. 11 is another flow chart of a method for inspecting installation of an air conditioner according to the first embodiment of the present invention.
Fig. 12 is a schematic view of a construction inspection apparatus according to a second embodiment of the present invention.
Fig. 13 is a structural diagram of a construction inspection system according to a third embodiment of the present invention.

### DESCRIPTION OF EMBODIMENTS

Preferred embodiments of the present invention will be described below with reference to the drawings.

### <First Embodiment>

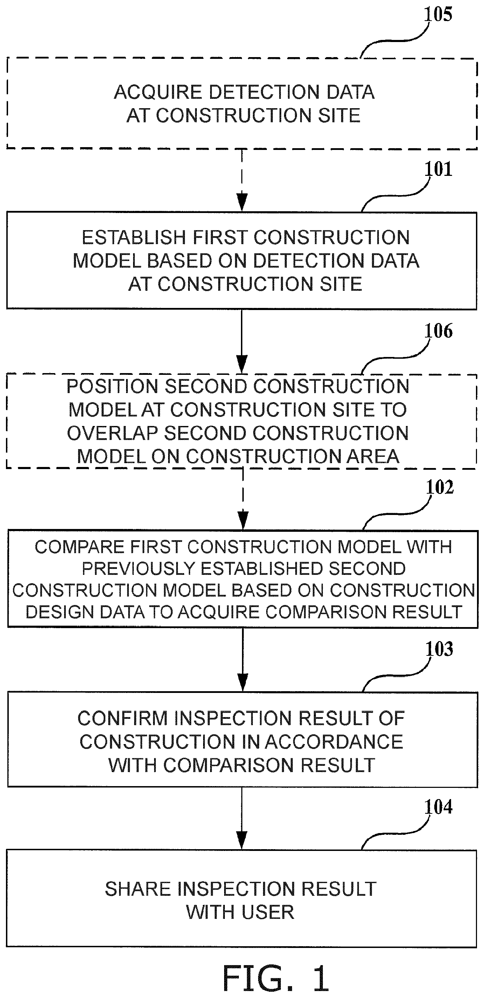

A first embodiment of the present invention provides a construction inspection method. Fig. 1 is a flow chart of the construction inspection method according to the first embodiment of the present invention. As illustrated in Fig. 1, the method includes the following steps:
Step 101: establishing a first construction model based on detection data at a construction site;
Step 102: comparing the first construction model with a previously established second construction model based on construction design data to acquire a comparison result;
Step 103: confirming an inspection result of a construction in accordance with the comparison result; and
Step 104: sharing the inspection result with a user.

Thus, the established model is compared with the design model based on the result actually detected at the site, and therefore the difference between the actually completed situation of the construction and the desired design plan may be accurately reflected, the accuracy of the inspection result may be high, and the inspection may also be performed according to a unified standard. In addition, as the two models are directly compared with each other, the processing process is simple, and the inspection efficiency is high. After the inspection result is obtained, the inspection result may also be shared with the user. Thus, the user at a location other than the site may also acquire the inspection result in a timely manner, which improves the inspection efficiency, enhances the convenience of inspection, saves time and effort, and improves the user experience.

The construction site may also be, for example, an operation site of a construction such as inside a building or may also be an outdoor site.

The construction inspection method may be used for inspection of various constructions, such as installation of air conditioners, according to the invention, or constructions of buildings, or interior constructions.

The construction inspection method may be applied to each stage during the construction, for example, intermediate inspection or completion inspection.

At Step 101, the first construction model is established based on detection data at the construction site.

The first construction model may be used to simulate a currently completed construction site and all components that are included in the construction and are present at the construction site, and the information of each component may be stored or marked in the first construction model.

For example, when the construction is installation of an air conditioner, the construction may include at least one of components such as an indoor unit, an outdoor unit, a refrigerant pipeline, an electric wire pipeline, a condensation pipeline, and a control panel.

The information of the component may be various types of information related to the component. For example, the information of the component may include at least one of the position, angle, model number, size, name, identifier, color, category, serial number, brand, material, and surface precision of the component.

The detection data may be various types of detection data with which the first construction model may be established. Examples thereof may include laser radar signals, image signals, or ground penetrating radar signals.

For example, as illustrated in Fig. 1, the construction inspection method may further include the following steps:
Step 105: acquiring the detection data at the construction site.

According to an embodiment of the present invention, Step 105 is a selectable step in the construction inspection method. For example, the detection data at the construction site may be acquired before the construction inspection method is performed.

For example, the construction site is scanned by a laser radar sensor to acquire a returned laser radar signal, and the first construction model is established based on the returned laser radar signal.

According to an embodiment of the present invention, the laser radar sensor may be provided in an augmented reality (Augmented Reality, AR) device, may be provided in a virtual reality (Virtual Reality, VR) device, or may be provided in a mixed reality (Mixed Reality, MR) device.

Thus, the AR device, the VR device, or the MR device may acquire the detection signal to establish the first construction model and thus intuitively observes the first construction model and may facilitate subsequent model comparison and inspection.

According to an embodiment of the present invention, the AR device may be various types of AR devices. Examples thereof may include AR glasses, smart phones, tablets, or customized AR hand-held devices.

For example, a laser radar sensor attached to the AR glasses transmits a laser radar signal to scan the entire construction site and acquires the laser radar signal returned to the sensor.

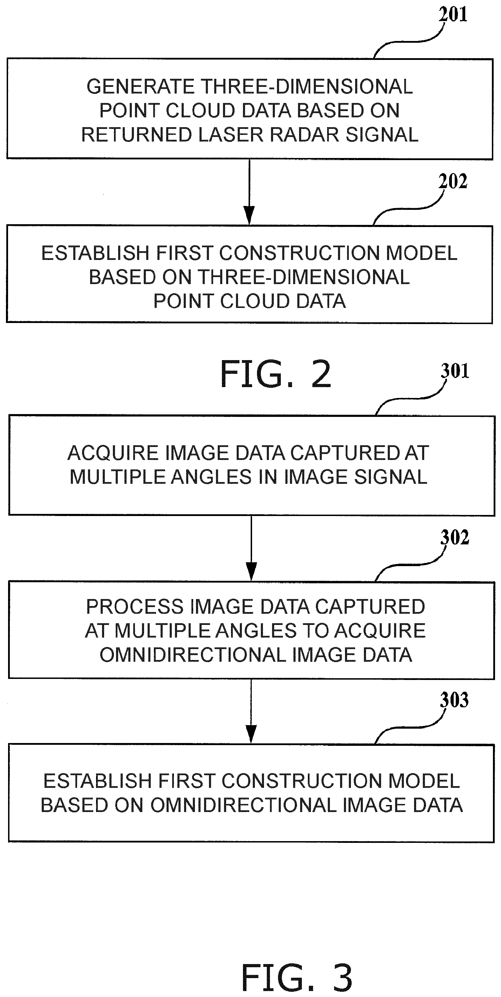

Fig. 2 is a flow chart of a method for implementing Step 101 using the laser radar signal according to the first embodiment of the present invention. As illustrated in Fig. 2, the method includes the following steps:
Step 201: generating three-dimensional point cloud data based on the returned laser radar signal; and
Step 202: establishing the first construction model based on the three-dimensional point cloud data.

For a specific modeling process, reference may be made to a related background art.

According to an embodiment of the present invention, for example, the construction site may be captured by an imaging device to acquire an image signal, and the first construction model may be established based on the image signal.

According to an embodiment of the present invention, the imaging device may be provided in an unmanned device or a robot. The construction site may be captured by the unmanned device or robot and thus captured at multiple angles and in all directions. Accordingly, the accuracy of the established first construction model is ensured.

Fig. 3 is a flow chart of a method for implementing Step 101 using an image signal according to the first embodiment of the present invention. As illustrated in Fig. 3, the method includes the following steps:
Step 301: acquiring image data captured at multiple angles in the image signal;
Step 302: processing the image data captured at the multiple angles to acquire omnidirectional image data; and
Step 303: establishing the first construction model based on the omnidirectional image data.

For example, the image signal is acquired by performing inclination capturing measurement by the unmanned device. For example, in the inclination capturing measurement, a ground object may be captured by five cameras mounted on the unmanned device from five directions, front, rear, left, right, and vertical directions, and then a series of processing such as geometric correction, balance adjustment, and multi-view video verification may be performed to acquire image data having omnidirectional information of the ground object, and then the first construction model may be modeled based on the image data. For a specific modeling process, reference may be made to a related background art.

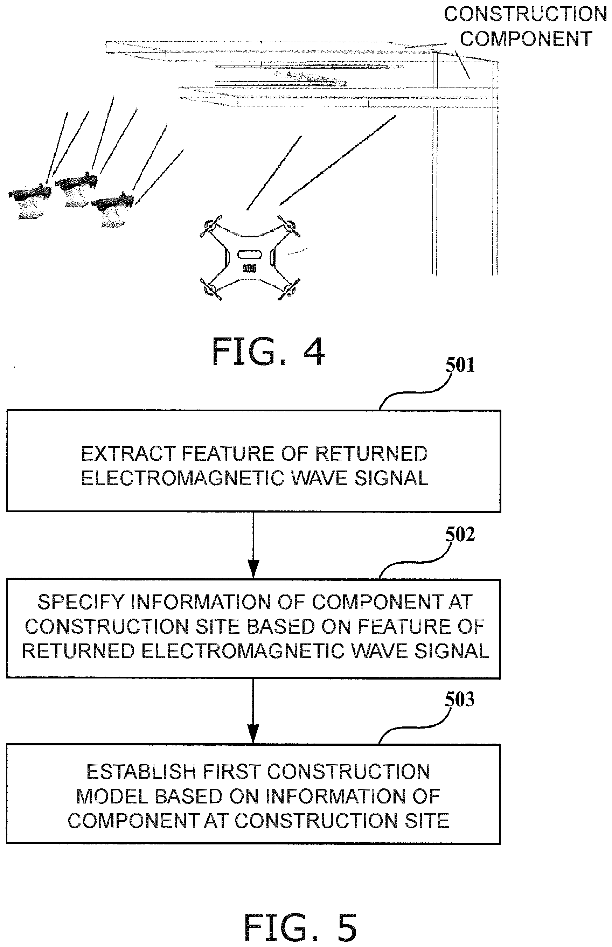

Fig. 4 is a schematic view of acquiring detection data by an AR device or an unmanned device according to the first embodiment of the present invention. As illustrated in Fig. 4, at the construction site, a worker scans the entire construction site while wearing AR glasses to acquire a returned laser radar signal or captures images of the construction site in all directions by using an unmanned device equipped with an imaging device to acquire an image.

According to an embodiment of the present invention, for example, a ground penetrating radar (Ground Penetrating Radar, GPR) device may further transmit a high-frequency electromagnetic wave to the construction site to acquire a returned electromagnetic wave signal and establish the first construction model based on the returned electromagnetic wave signal. By establishing the first construction model with the ground penetrating radar signal, internal structures, which cannot be observed from outside, may be modeled. Examples thereof may include dark pipelines in a wall or underground, and various devices or structures closed by a ceiling.

Fig. 5 is a flow chart of a method for implementing Step 101 using the ground penetrating radar signal according to the first embodiment of the present invention. As illustrated in Fig. 5, the method includes the following steps:
Step 501: extracting a feature of the returned electromagnetic wave signal;
Step 502: specifying information of a component at the construction site based on the feature of the returned electromagnetic wave signal; and
Step 503: establishing the first construction model based on the information of the component at the construction site.

For example, high-frequency electromagnetic waves are transmitted to the construction site by a transmitting antenna, and reflected electromagnetic waves are received by a receiving antenna, electromagnetic waves are reflected when they encounter a boundary surface having an electrical difference during propagation, and the spatial position, structure, form, embedding depth, and the like, of an internal component are inferred in accordance with the characteristics of the waveform, amplitude intensity, and temporal change of the received electromagnetic waves to acquire the information of the component, and the first construction model is established based on the information of the component at the construction site. For a specific modeling process, reference may be made to a background art.

According to an embodiment of the present invention, it is possible to determine which one of the laser radar signal, the image signal, and the ground penetrating radar signal is used to establish the first construction model according to an application situation.

For example, when the construction may be observed from outside, the laser radar signal or the image signal may be used to establish the first construction model; however, when it is difficult to observe the construction from outside or it is difficult to observe some components in the construction from outside, the ground penetrating radar signal may be used to establish the first construction model.

For example, for the installation of a central air conditioner, when the installation of the air conditioner is finished and there is no ceiling, the first construction model may be established by using the laser radar signal or the image signal, but when the installation of the air conditioner is finished and there is a ceiling, the first construction model may be established by using the ground penetrating radar signal.

According to an embodiment of the present invention, as described above, the information of the component in the first construction model may include at least one of the position, angle, model number, size, name, identifier, color, category, serial number, brand, material, and surface precision of the component. When it is difficult to directly acquire some of the information from the detection signal, it may be acquired in combination with other techniques.

For example, the image signal is input into a previously established AI model to be identified and determine the material of the component.

In addition, according to an embodiment of the present invention, various detection signals may be combined to establish the first construction model. For example, the laser radar signal and the ground penetrating radar signal may be combined to establish the first construction model.

According to an embodiment of the present invention, after the first construction model is established, in Step 102, the first construction model is compared with the previously established second construction model based on construction design data to acquire a comparison result.

According to an embodiment of the present invention, the second construction model is previously established based on the design data of the construction and may be various three-dimensional models. For example, the second construction model may be a building information model (Building Information Modeling, BIM).

According to an embodiment of the present invention, the second construction model may include information of all the components in the construction, and the information of the components may be various types of information related to the components. For example, the information of the component may include at least one of the position, angle, model number, size, name, identifier, color, category, serial number, brand, material, and surface precision of the component.

According to an embodiment of the present invention, the data of the second construction model may be previously stored in a terminal device used at the inspection site, such as an AR device.

Alternatively, the data of the second construction model may be acquired by the terminal device from a server of a cloud terminal.

According to an embodiment of the present invention, for example, as illustrated in Fig. 1, the following steps may be further included before Step 102:
Step 106: positioning the second construction model at the construction site to superimpose the second construction model on a construction area and displaying the second construction model by the augmented reality device. Furthermore, the first construction model and the comparison result may be displayed by the augmented reality device.

Accordingly, the second construction model matched with the position of the construction site, the established first construction model, and the comparison result are displayed on the site by the AR device, which is an augmented reality device, and thus the accuracy of inspection is improved, and the difference between the two models, i.e., the comparison result, may be intuitively observed.

According to an embodiment of the present invention, Step 106 is a selectable step.

According to an embodiment of the present invention, the second construction model may not be positioned at the construction site. In this way, the efficiency of the operation at the site is increased, and the flexibility is high.

According to an embodiment of the present invention, the positioning of the second construction model may be implemented in various ways.

For example, positioning may be performed with two location points at the construction area. The positioning operation with two points is simple and suitable for a wide range of personnel. By simply establishing two points on the ground, the second construction model and the construction area, e.g., a building body, may be positioned together.

Further, for example, positioning may be performed with a wall at the construction area. The positioning with the wall is positioning with three points, which may further increase the superimposition accuracy of the second construction model and the construction area and further improves the inspection accuracy.

Further, for example, the positioning may be performed by scanning a two-dimensional code installed at the construction area. For example, the two-dimensional code includes information of one wall at the construction area. Thus, the superimposition accuracy between the second construction model and the construction area may be further increased, and the accuracy of inspection is further improved. At the same time, the time required for point calibration is saved, and the accuracy of inspection is further improved.

Further, for example, positioning may be performed by a geographic information system (Geographic Information System, GIS).

According to an embodiment of the present invention, the construction inspection method may further include a step of matching a coordinate point of the first construction model to coincide with a coordinate point of the second construction model. Accordingly, the accuracy of the comparison result between the first construction model and the second construction model is increased, and the accuracy of inspection is further improved.

For example, when the first construction model is established, the coordinate point of the first construction model may be matched to coincide with the coordinate point of the second construction model. Accordingly, after the first construction model is established, it may be directly compared with the second construction model so that the processing process is simple and the inspection efficiency may be further improved.

Further, for example, when the first construction model is compared with the second construction model, matching may be performed such that the coordinate point of the first construction model coincides with the coordinate point of the second construction model. Accordingly, it is not necessary to perform alignment with respect to the model at the site, and thus labor saving may be achieved.

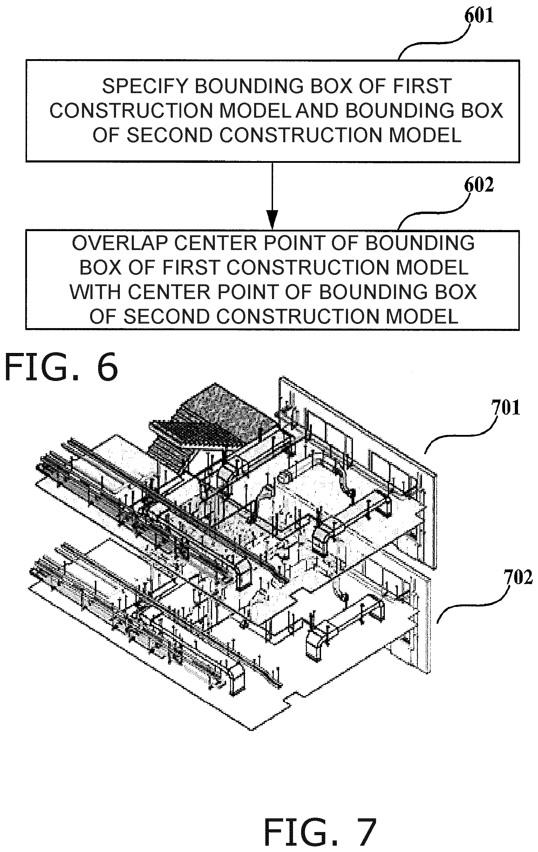

Fig. 6 is a schematic view of a method for model alignment according to the first embodiment of the present invention. As illustrated in Fig. 6, the method includes the following steps:
Step 601: specifying a bounding box of the first construction model and a bounding box of the second construction model; and
Step 602: overlapping a center point of the bounding box of the first construction model with a center point of the bounding box of the second construction model.

At Step 102, collisional verification between the first construction model and the second construction model may be performed to acquire the comparison result.

Fig. 7 is a schematic view of collisional verification between the first construction model and the second construction model according to the first embodiment of the present invention. As illustrated in Fig. 7, 701 indicates the first construction model, 702 indicates the second construction model, and the comparison result is acquired by performing collisional verification between the two models.

In Step 102, the information of all the components in the first construction model may be compared with the information of the corresponding components in the second construction model one by one to specify the component having a mismatch. For example, the ID of the component having a mismatch may be recorded. In addition, specific content of the mismatch may be recorded.

For example, the information of the component may include at least one of the position, angle, model number, size, name, identifier, color, category, serial number, brand, material, and surface precision of the component.

According to an embodiment of the present invention, the construction inspection method may further include a step of marking the component having the mismatch in the second construction model, and a step of displaying, by an augmented reality device, the second construction model in which the component having the mismatch is marked. Accordingly, it is possible to intuitively observe the component having a mismatch.

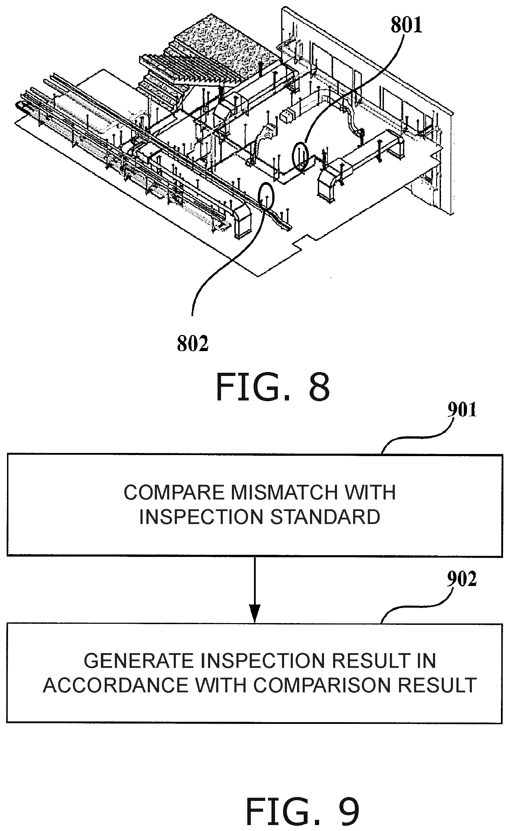

Fig. 8 is a schematic view of marking the component having a mismatch according to the first embodiment of the present invention. As illustrated in Fig. 8, in the second construction model 702, components 801 and 802 having mismatches are marked. Further, specific content of the mismatch may be displayed at the same time. For example, the degree of mismatch in position or angle may be displayed.

After acquiring the comparison result, in Step 103, the inspection result of the construction is confirmed in accordance with the comparison result.

Fig. 9 is a flow chart of a method for implementing Step 103 according to the first embodiment of the present invention. As illustrated in Fig. 9, the method includes the following steps:
Step 901: comparing the mismatch with an inspection standard; and
Step 902: generating the inspection result in accordance with the comparison result.

For example, when the position mismatch is greater than the position mismatch defined in the inspection standard, it is confirmed that the construction is defective, and when the position mismatch is less than or equal to the position mismatch defined in the inspection standard, it is confirmed that the construction is successful.

For various constructions, inspection standards in different industries or self-defined inspection standards by manufacturers may be used.

For example, for the installation of air conditioners, the inspection standard may include a pipeline and wiring inspection standard of air conditioners, and the inspection items are air conditioners, liquid pipes, gas pipes, supporting and lifting brackets, buckles, pipe joints, ducts, valves, and the like.

For example, the quality inspection items of the air conditioner may include a device model number, spatial position, horizontal angle, and vertical angle. Here, it is assumed that the position mismatch of the air conditioner is ±20 cm or less and the angle mismatch is ±10° or less. The liquid pipe and the gas pipe are requested to be provided with a thermal insulation material, the position mismatch of the liquid pipe and the gas pipe is ±30 cm or less, and the inclination angle is requested to meet the design requirement and not to exceed 10% beyond the range. The interval of the supporting and lifting bracket is requested to meet the design requirements and not to exceed 20% beyond the designed interval, and the inclination angle is requested not to exceed 10%. A shock absorbing pad is requested to be attached to a hanging leg. Buckles are requested to be rigid, and the number is requested to meet the design requirements. The quality inspection of the ducts is performed in accordance with the categories of the material, the machining process, and the system, and the quality inspection is requested to meet the design requirements, including the material, specification (radius and length), strength, and strictness of the ducts. The mounting position, height, and inlet and outlet directions of valves need to meet the design requirements, and the connection need to be secure and tight.

According to an embodiment of the present invention, the construction inspection method may further include a step of displaying an inspection result by a virtual reality (VR) device. For example, by transmitting the inspection result to the VR device and displaying the inspection result on the construction site or remotely by the VR device, the worker or the user may intuitively confirm the inspection result.

After the inspection result is acquired, in Step 104, the inspection result may be shared with the user. According to an embodiment of the present invention, the user is a user who is not at the construction site at the time of inspection.

For example, the inspection result may be transmitted to a server of the cloud terminal and shared with a specific user.

According to an embodiment of the present invention, the specific user is, for example, a client or another inspector who is not at the construction site.

In addition, according to an embodiment of the present invention, the second construction model may also be updated according to the inspection result.

According to an embodiment of the present invention, the construction inspection method may be implemented by local processing. That is, it is executed by a terminal device at the inspection site. For example, it may be executed by an AR device.

Alternatively, the construction inspection method may be implemented by processing using a cloud terminal. That is, it may be executed by a server of a cloud terminal.

For example, the terminal device at the inspection site may transmit the detection data to the server of the cloud terminal, and the server of the cloud terminal may execute each step of the construction inspection method.

The process in the cloud terminal and the process in the local terminal according to the construction inspection method will be described below in detail by taking the installation of the air conditioner as an example.

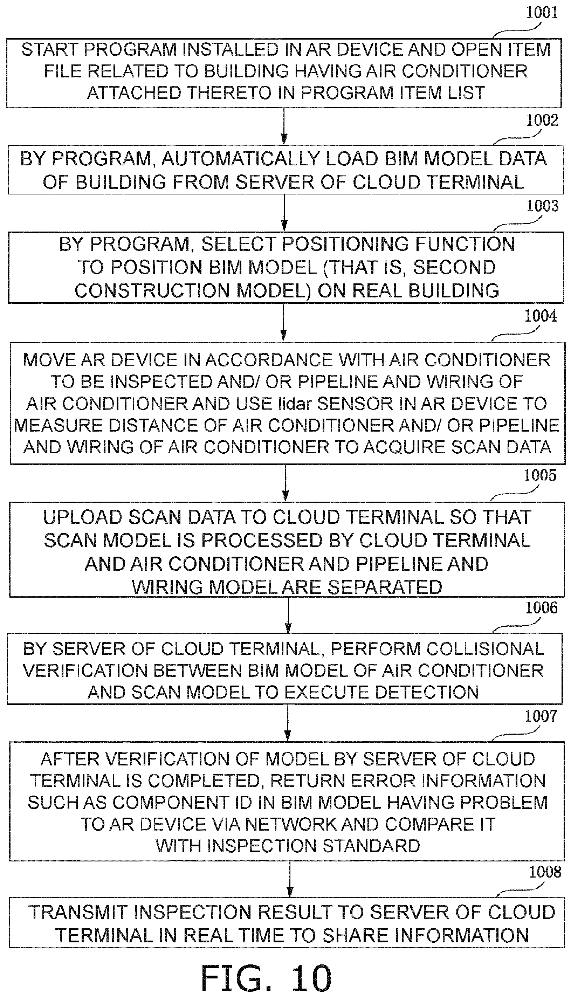

Fig. 10 is a flow chart of a method for inspecting the installation of an air conditioner according to the first embodiment of the present invention. As illustrated in Fig. 10, the method includes the following steps:
Step 1001: starting a program installed in the AR device and opening an item file related to the building having the air conditioner attached thereto in a program item list;
Step 1002: by the program, automatically loading BIM model data (e.g., the model type is .rvt or .fbx) of the building from the server of the cloud terminal, including the model and data of the building, the air conditioner, and the pipeline and wiring data of the air conditioner;
Step 1003: by the program, selecting a positioning function to position the BIM model (that is, the second construction model) on the real building. Accordingly, the effect of superimposition between the 3D virtual building and the real building is obtained. For example, the positioning may be performed by positioning with two points, positioning with a wall, or positioning by scanning a two-dimensional code.
Step 1004: moving the AR device in accordance with the air conditioner to be inspected and/or the pipeline and wiring of the air conditioner and using the lidar sensor in the AR device to measure the distance of the air conditioner and/or the pipeline and wiring of the air conditioner to acquire scan data;
Step 1005: uploading the scan data to the cloud terminal so that the scan model is processed by the cloud terminal and the air conditioner and the pipeline and wiring model are separated;
Step 1006: by the server of the cloud terminal, performing collisional verification between the BIM model of the air conditioner and the scan model to execute detection. When there is an inconsistent part between the two, the ID of the corresponding component in the BIM model is recorded, and the cause of inconsistency is also recorded, for example, the mismatch of the inclination angle, the mismatch of the position, or the misuse of the material.
Step 1007: after the verification of the model by the server of the cloud terminal is completed, returning error information such as the component ID in the BIM model having a problem to the AR device via a network and comparing it with the inspection standard. For those that do not meet the inspection standard, the AR device finds and marks the corresponding component locally from the component ID and marks the problem of construction and design difference in the model. Thus, the inspector may grasp mismatches in the contents of the construction and the contents of the design at a glance.
Step 1008: transmitting the inspection result to the server of the cloud terminal in real time to share information. Then, the owner or the construction team may view the inspection result in real time, which facilitates subsequent corrections for the inspection result and accelerates the inspection procedure.

Accordingly, the server of the cloud terminal mainly performs the process of inspection, which increases the processing speed and lowers the requirement on the processing capability of the hardware of the AR device.

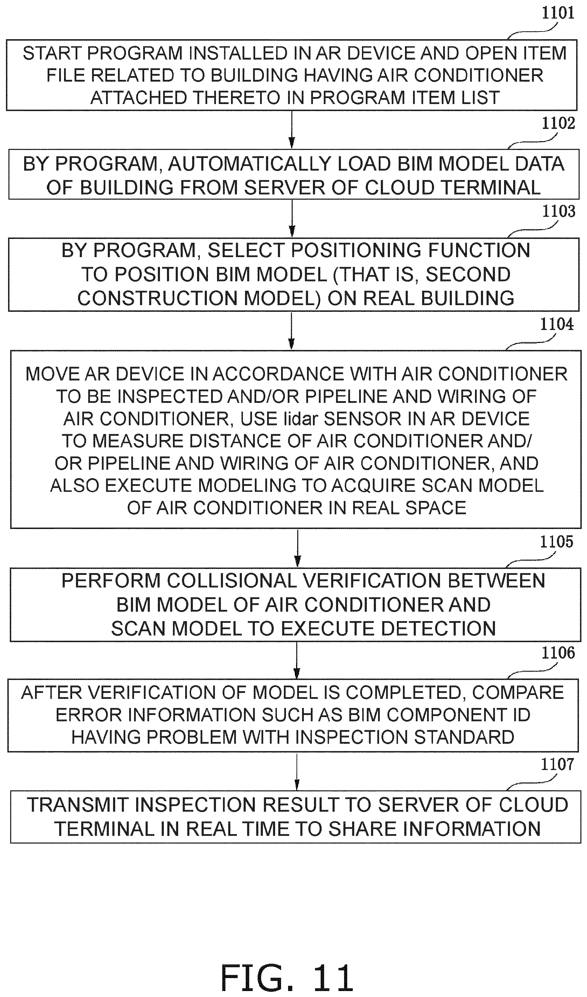

Fig. 11 is another flow chart of the method for inspecting the installation of the air conditioner according to the first embodiment of the present invention. As illustrated in Fig. 11, the method includes the following steps:
Step 1101: starting a program installed in the AR device and opening an item file related to the building having the air conditioner attached thereto in a program item list;
Step 1102: by the program, automatically loading BIM model data (e.g., the model type is .rvt or .fbx) of the building from the server of the cloud terminal, including the model and data of the building, the air conditioner, and the pipeline and wiring data of the air conditioner;
Step 1103: selecting a positioning function in the program to position the BIM model (that is, the second construction model) on the real building. Accordingly, the effect of superimposition between the 3D virtual building and the real building is obtained. For example, the positioning may be performed by positioning with two points, positioning with a wall, or positioning by scanning a two-dimensional code.
Step 1104: moving the AR device in accordance with the air conditioner to be inspected and/or the pipeline and wiring of the air conditioner, using the lidar sensor in the AR device to measure the distance of the air conditioner and/or the pipeline and wiring of the air conditioner, and also executing modeling to acquire and store the first construction model that is a scan model of the air conditioner in the real space;
Step 1105: performing collisional verification between the BIM model of the air conditioner and the scan model to execute detection. When there is an inconsistent part between the two, the ID of the corresponding component in the BIM model is recorded, and the cause of inconsistency is also recorded, for example, the mismatch of the inclination angle, the mismatch of the position, or the misuse of the material.
Step 1106: after the verification of the model is completed, comparing the error information such as the BIM component ID having a problem with the inspection standard. For those that do not meet the inspection standard, the AR device finds and marks the corresponding component locally from the component ID and marks the problem of construction and design difference in the model. Thus, the inspector may grasp mismatches in the contents of the construction and the contents of the design at a glance.
Step 1107: transmitting the inspection result to the server of the cloud terminal in real time to share information. Then, the owner or the construction team may view the inspection result in real time, which facilitates subsequent corrections for the inspection result and accelerates the inspection procedure.

Accordingly, the process of inspection by the local terminal device is mainly performed, which may be applied to various network states.

As may be understood from the above embodiment, the first construction model is established at the construction site based on the detection data at the site, the first construction model is compared with the previously established second construction model based on the design data, and the inspection result is confirmed in accordance with the comparison result so that the model established based on the result actually detected at the site is compared with the design model, and therefore it is possible to accurately reflect the difference between the actually completed situation of the construction and the desired design plan, the inspection result may be highly accurate, and the inspection may also be performed according to a unified standard. In addition, as the two models are directly compared with each other, the processing process is simple, and the inspection efficiency is high. After the inspection result is acquired, the inspection result may be shared with the user. Thus, the user at a location other than the site may also acquire the inspection result in a timely manner, which improves the inspection efficiency, enhances the convenience of inspection, saves time and effort, and improves the user experience.

### <Second Embodiment>

A second embodiment of the present invention provides a construction inspection apparatus corresponding to the construction inspection method described in the first embodiment and, for the specific implementation thereof, reference may be made to the implementation of the method described in the first embodiment, and the descriptions may be omitted for the identical or related contents.

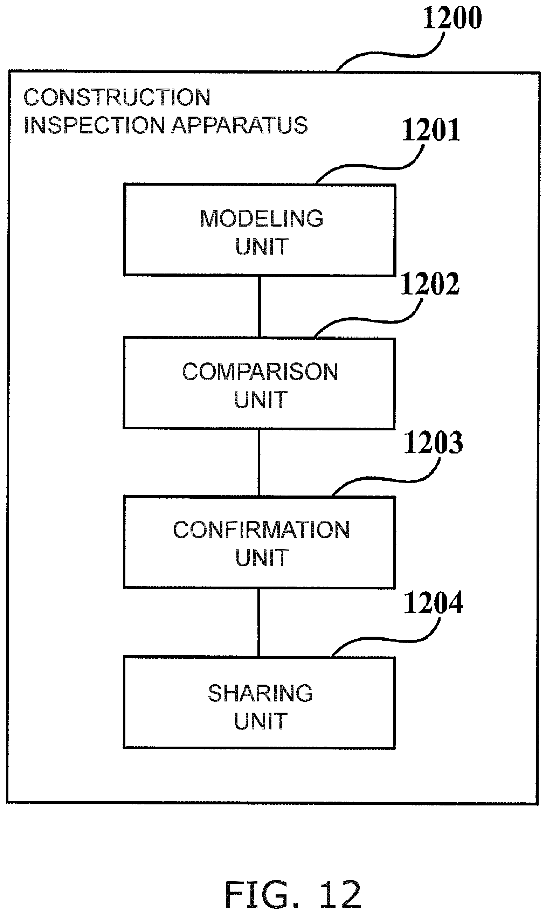

Fig. 12 is a schematic view of a construction inspection apparatus according to the second embodiment of the present invention. As illustrated in Fig. 12, a construction inspection apparatus 1200 includes
a modeling unit 1201 that establishes a first construction model based on detection data at the construction site,
a comparison unit 1202 that compares the first construction model with a previously established second construction model based on construction design data to acquire a comparison result,
a confirmation unit 1203 that confirms an inspection result of a construction in accordance with the comparison result, and
a sharing unit 1204 that shares the inspection result with the user.

According to an embodiment of the present invention, the construction inspection apparatus 1200 may be installed in a terminal device and/or a server of a cloud terminal.

According to an embodiment of the present invention, for the implementation of the function of each of the units, reference may be made to the contents of the related steps according to the first embodiment. The descriptions thereof may be omitted here.

As may be understood from the above embodiment, the first construction model is established at the construction site based on the detection data at the site, the first construction model is compared with the previously established second construction model based on the design data, and the inspection result is confirmed in accordance with the comparison result so that the model established based on the result actually detected at the site is compared with the design model, and therefore it is possible to accurately reflect the difference between the actually completed situation of the construction and the desired design plan, the inspection result may be highly accurate, and the inspection may also be performed according to a unified standard. In addition, as the two models are directly compared with each other, the processing process is simple, and the inspection efficiency is high. After the inspection result is acquired, the inspection result may be shared with the user. Thus, the user at a location other than the site may also acquire the inspection result in a timely manner, which improves the inspection efficiency, enhances the convenience of inspection, saves time and effort, and improves the user experience.

### <Third Embodiment>

A third embodiment of the present invention provides a construction inspection system including the construction inspection apparatus according to the second embodiment and, for the specific implementation thereof, reference may be made to the implementation of the apparatus described in the second embodiment and the method described in the first embodiment, and the descriptions may be omitted for the identical or related contents.

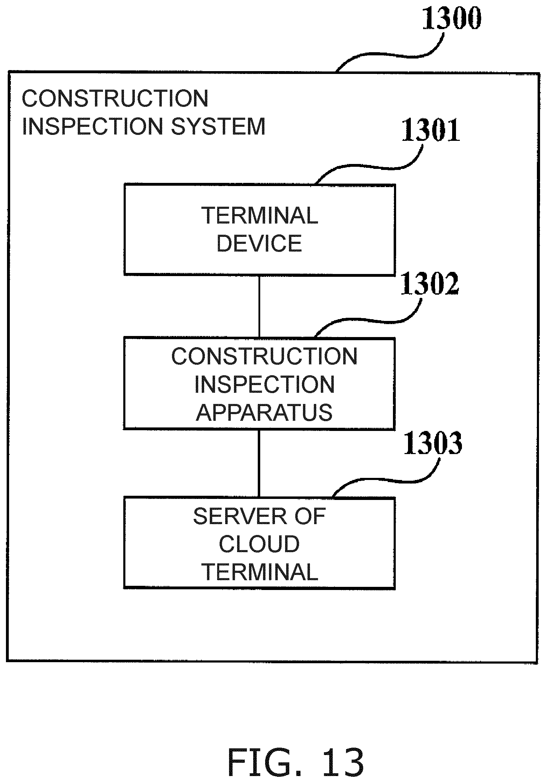

Fig. 13 is a structural diagram of a construction inspection system according to a third embodiment of the present invention. As illustrated in Fig. 13, a construction inspection system 1300 includes
a terminal device 1301 that acquires detection data at a construction site, and
a construction inspection apparatus 1302 that confirms an inspection result of a construction based on the detection data at the construction site and a previously established second construction model based on construction design data.

As illustrated in Fig. 13, the construction inspection system 1300 may further include
a server 1303 of a cloud terminal that stores data of the second construction model.

The server 1303 may receive the inspection result of the construction and share it with a specific user.

The construction inspection apparatus 1302 may be an individual device or may be integrated into the terminal device 1301 and/or the server 1303 of the cloud terminal.

For the specific structure and function of the construction inspection apparatus 1302, reference may be made to the apparatus described in the second embodiment and the method described in the first embodiment, and the descriptions may be omitted here.

As may be understood from the above embodiment, the first construction model is established at the construction site based on the detection data at the site, the first construction model is compared with the previously established second construction model based on the design data, and the inspection result is confirmed in accordance with the comparison result so that the model established based on the result actually detected at the site is compared with the design model, and therefore it is possible to accurately reflect the difference between the actually completed situation of the construction and the desired design plan, the inspection result may be highly accurate, and the inspection may also be performed according to a unified standard. In addition, as the two models are directly compared with each other, the processing process is simple, and the inspection efficiency is high. After the inspection result is acquired, the inspection result may be shared with the user. Thus, the user at a location other than the site may also acquire the inspection result in a timely manner, which improves the inspection efficiency, enhances the convenience of inspection, saves time and effort, and improves the user experience.

The above apparatus and method according to the embodiments of the present invention may be implemented by hardware or may be implemented by a combination of hardware and software. The latter relates to a computer-readable program below. When the program is executed by a logic unit, the logic unit may implement the above devices or components or implement the above various methods or steps.

A storage medium that stores the above program can be a hard disk, a magnetic disk, an optical disk, a DVD, or a flash memory.

It should be noted that, on the premise that the limitation of each step according to the present solution does not affect the implementation of the specific solution, the sequence of the steps is not limited, and the steps described above may be executed first, or may be executed later, or may be executed simultaneously. Any implementation of the present solution should be regarded as falling within the protection scope of the present invention, as defined by the claims.

The present invention has been described above with reference to specific embodiments. However, it should be understood by those skilled in the art that these descriptions are merely exemplary and those skilled in the art may make various changes and modifications to the present invention, within the scope of the present invention, as defined by the claims.

## Claims

1. A computer-implemented construction inspection method comprising:
a step of establishing a first construction model based on detection data at a construction site;
a step of comparing the first construction model with a previously established second construction model based on construction design data to acquire a comparison result;
a step of confirming an inspection result of a construction in accordance with the comparison result; and
a step of sharing the inspection result with a user,
**characterized in that**
the first construction model is a scan model of an air conditioner in a real space, wherein the second construction model is a building information model, BIM model, of an air conditioner, the step of comparing the first construction model with the previously established second construction model based on the construction design data to acquire the comparison result includes a step of performing collisional verification between the first construction model and the second construction model to acquire the comparison result, wherein when there is an inconsistent part between the first construction model and the second construction model, an ID of the corresponding component in the BIM model and the cause of inconsistency are recorded.

2. The construction inspection method according to claim 1, further comprising a step of acquiring the detection data, wherein the step of acquiring the detection data includes
a step of scanning the construction site by a laser radar sensor to acquire a returned laser radar signal,
a step of capturing the construction site by an imaging device to acquire an image signal, or
a step of transmitting a high-frequency electromagnetic wave to the construction site by a ground penetrating radar device to acquire a returned electromagnetic wave signal.

3. The construction inspection method according to claim 2, wherein
the laser radar sensor is provided in an augmented reality device, and/or
the imaging device is provided in an unmanned device or a robot.

4. The construction inspection method according to claim 2, wherein the step of establishing the first construction model based on the detection data at the construction site includes
a step of generating three-dimensional point cloud data based on the returned laser radar signal, and
a step of establishing the first construction model based on the three-dimensional point cloud data.

5. The construction inspection method according to claim 2, wherein the step of establishing the first construction model based on the detection data at the construction site includes
a step of acquiring image data captured at multiple angles in the image signal,
a step of processing the image data captured at the multiple angles to acquire omnidirectional image data, and
a step of establishing the first construction model based on the omnidirectional image data.

6. The construction inspection method according to claim 2, wherein the step of establishing the first construction model based on the detection data at the construction site includes
a step of extracting a feature of the returned electromagnetic wave signal,
a step of specifying information of a component at the construction site based on the feature of the returned electromagnetic wave signal, and
a step of establishing the first construction model based on the information of the component at the construction site.

7. The construction inspection method according to claim 1, further comprising, before comparing the first construction model with the second construction model, a step of positioning the second construction model at the construction site to superimpose the second construction model on a construction area and displaying the second construction model by an augmented reality device.

8. The construction inspection method according to claim 7, further comprising a step of displaying the first construction model and the comparison result by the augmented reality device.

9. The construction inspection method according to claim 7, wherein the step of positioning the second construction model at the construction site includes
a step of positioning with two location points at the construction area,
a step of positioning with a wall at the construction area, or
a step of positioning by scanning a two-dimensional code installed at the construction area.

10. The construction inspection method according to claim 1, further comprising a step of matching a coordinate point of the first construction model to coincide with a coordinate point of the second construction model.

11. The construction inspection method according to claim 10, wherein the step of matching the coordinate point of the first construction model to coincide with the coordinate point of the second construction model includes
a step of, before establishing the first construction model, matching the coordinate point of the first construction model to coincide with the coordinate point of the second construction model, or
a step of matching the coordinate point of the first construction model to coincide with the coordinate point of the second construction model when comparing the first construction model with the second construction model.

12. The construction inspection method according to claim 11, wherein the step of matching the coordinate point of the first construction model to coincide with the coordinate point of the second construction model when comparing the first construction model with the second construction model includes
a step of specifying a bounding box of the first construction model and a bounding box of the second construction model, and
a step of overlapping a center point of the bounding box of the first construction model with a center point of the bounding box of the second construction model.

13. The construction inspection method according to claim 1, wherein the step of comparing the first construction model with the previously established second construction model based on the construction design data to acquire the comparison result includes a step of comparing information of all components in the first construction model with information of corresponding components in the second construction model one by one to specify a component having a mismatch.

14. The construction inspection method according to claim 13, wherein the information of the component includes at least one of a position, angle, model number, size, name, identifier, color, category, serial number, brand, material, and surface precision of the component.

15. The construction inspection method according to claim 13, further comprising:
a step of marking the component having the mismatch in the second construction model; and
a step of displaying, by an augmented reality device, the second construction model in which the component having the mismatch is marked.

16. The construction inspection method according to claim 13, wherein the step of confirming the inspection result of the construction in accordance with the comparison result includes
a step of comparing the mismatch with an inspection standard, and
a step of generating the inspection result in accordance with the comparison result.

17. The construction inspection method according to claim 1, further comprising a step of displaying the inspection result by a virtual reality device.

18. The construction inspection method according to claim 1, further comprising a step of updating the second construction model according to the inspection result.

19. A construction inspection apparatus comprising:
a modeling unit that establishes a first construction model based on detection data at a construction site;
a comparison unit that compares the first construction model with a previously established second construction model based on construction design data to acquire a comparison result;
a confirmation unit that confirms an inspection result of a construction in accordance with the comparison result; and
a sharing unit that shares the inspection result with a user,
wherein the first construction model is a scan model of an air conditioner in a real space, the second construction model is a building information model, BIM model, of an air conditioner, the comparison unit is configured to perform collisional verification between the first construction model and the second construction model to acquire the comparison result, when there is an inconsistent part between the first construction model and the second construction model, wherein an ID of the corresponding component in the BIM model and the cause of inconsistency are recorded.

20. A construction inspection system comprising:
a terminal device that acquires detection data at a construction site; and
the construction inspection apparatus according to claim 19 that confirms an inspection result of a construction based on the detection data at the construction site and a previously established second construction model based on construction design data.

## Patentansprüche

1. Computerimplementiertes Verfahren zur Bauinspektion, umfassend:
einen Schritt zum Erstellen eines ersten Bauwerksmodells basierend auf Erkennungsdaten an einer Baustelle;
einen Schritt zum Vergleichen des ersten Bauwerksmodells mit einem zuvor erstellten zweiten Bauwerksmodell basierend auf Bauwerksgestaltungsdaten, um ein Vergleichsergebnis zu erfassen;
einen Schritt zum Bestätigen eines Inspektionsergebnisses eines Bauwerks im Einklang mit dem Vergleichsergebnis; und
einen Schritt zum Weitergeben des Inspektionsergebnisses an einen Nutzer,
**dadurch gekennzeichnet, dass** das erste Bauwerksmodell ein Scan-Modell einer Klimaanlage in einem realen Raum ist, wobei das zweite Bauwerksmodell ein Bauwerksinformationsmodell, BIM-Modell, einer Klimaanlage ist,
wobei der Schritt zum Vergleichen des ersten Bauwerksmodells mit dem zuvor erstellten zweiten Bauwerksmodell basierend auf den Bauwerksgestaltungsdaten, um das Vergleichsergebnis zu erfassen, einen Schritt zum Durchführen einer Kollisionsprüfung zwischen dem ersten Bauwerksmodell und dem zweiten Bauwerksmodell einschließt, um das Vergleichsergebnis zu erfassen, wobei, wenn ein nicht übereinstimmender Teil zwischen dem ersten Bauwerksmodell und dem zweiten Bauwerksmodell vorliegt, eine ID der entsprechenden Komponente im BIM-Modell und die Ursache der fehlenden Übereinstimmung aufgezeichnet werden.

2. Verfahren zur Bauinspektion nach Anspruch 1, ferner umfassend einen Schritt zum Erfassen der Erkennungsdaten, wobei der Schritt zum Erfassen der Erkennungsdaten Folgendes einschließt
einen Schritt zum Scannen der Baustelle durch einen Laserradarsensor, um ein zurückgesendetes Laserradarsignal zu erfassen,
einen Schritt zum Erheben der Baustelle durch eine Bildgebungsvorrichtung, um ein Bildsignal zu erfassen, oder
einen Schritt zum Übertragen einer hochfrequenten elektromagnetischen Welle an die Baustelle durch eine Boden-Penetrationsradarvorrichtung, um ein zurückgesendetes elektromagnetisches Wellensignal zu erfassen.

3. Verfahren zur Bauinspektion nach Anspruch 2, wobei der Laserradarsensor in einer Augmented-Reality-Vorrichtung bereitgestellt ist und/oder die Bildgebungsvorrichtung in einer unbemannten Vorrichtung oder einem Roboter bereitgestellt ist.

4. Verfahren zur Bauinspektion nach Anspruch 2, wobei der Schritt zum Erstellen des ersten Bauwerksmodells basierend auf den Erkennungsdaten an der Baustelle Folgendes einschließt
einen Schritt zum Generieren von dreidimensionalen Punktwolkendaten basierend auf dem zurückgesendeten Laserradarsignal, und
einen Schritt zum Erstellen des ersten Bauwerksmodells basierend auf den dreidimensionalen Punktwolkendaten.

5. Verfahren zur Bauinspektion nach Anspruch 2, wobei der Schritt zum Erstellen des ersten Bauwerksmodells basierend auf den Erkennungsdaten an der Baustelle Folgendes einschließt
einen Schritt zum Erfassen von an mehreren Winkeln im Bildsignal erhobenen Bilddaten,
einen Schritt zum Verarbeiten der an den mehreren Winkeln erhobenen Bilddaten, um omnidirektionale Bilddaten zu erfassen, und
einen Schritt zum Erstellen des ersten Bauwerksmodells basierend auf den omnidirektionalen Bilddaten.

6. Verfahren zur Bauinspektion nach Anspruch 2, wobei der Schritt zum Erstellen des ersten Bauwerksmodells basierend auf den Erkennungsdaten an der Baustelle Folgendes einschließt
einen Schritt zum Extrahieren eines Merkmals des zurückgesendeten elektromagnetischen Wellensignals, einen Schritt zum Angeben von Informationen einer Komponente an der Baustelle basierend auf dem Merkmal des zurückgesendeten elektromagnetischen Wellensignals, und
einen Schritt zum Erstellen des ersten Bauwerksmodells basierend auf den Informationen der Komponente an der Baustelle.

7. Verfahren zur Bauinspektion nach Anspruch 1, ferner umfassend - vor dem Vergleichen des ersten Bauwerksmodells mit dem zweiten Bauwerksmodell - einen Schritt zum Positionieren des zweiten Bauwerksmodells an der Baustelle, um das zweite Bauwerksmodell auf einem Bauwerksbereich zu überlagern, und zum Anzeigen des zweiten Bauwerksmodells durch eine Augmented-Reality-Vorrichtung.

8. Verfahren zur Bauinspektion nach Anspruch 7, ferner umfassend einen Schritt zum Anzeigen des ersten Bauwerksmodells und des Vergleichsergebnisses durch die Augmented-Reality-Vorrichtung.

9. Verfahren zur Bauinspektion nach Anspruch 7, wobei der Schritt zum Positionieren des zweiten Bauwerksmodells an der Baustelle Folgendes einschließt einen Schritt zum Positionieren mit zwei Standortpunkten am Bauwerksbereich,
einen Schritt zum Positionieren mit einer Wand am Bauwerksbereich, oder
einen Schritt zum Positionieren per Scannen eines am Bauwerksbereich installierten zweidimensionalen Codes.

10. Verfahren zur Bauinspektion nach Anspruch 1, ferner umfassend einen Schritt zum Abgleichen eines Koordinatenpunkts des ersten Bauwerksmodells, um mit einem Koordinatenpunkt des zweiten Bauwerksmodells übereinzustimmen.

11. Verfahren zur Bauinspektion nach Anspruch 10, wobei der Schritt zum Abgleichen des Koordinatenpunkts des ersten Bauwerksmodells, um mit einem Koordinatenpunkt des zweiten Bauwerksmodells übereinzustimmen, Folgendes einschließt
vor dem Erstellen des ersten Bauwerksmodells einen Schritt zum Abgleichen des Koordinatenpunkts des ersten Bauwerksmodells, um mit dem Koordinatenpunkt des zweiten Bauwerksmodells übereinzustimmen, oder
einen Schritt zum Abgleichen des Koordinatenpunkts des ersten Bauwerksmodells, um mit dem Koordinatenpunkt des zweiten Bauwerksmodells übereinzustimmen, wenn das erste Bauwerksmodell mit dem zweiten Bauwerksmodell verglichen wird.

12. Verfahren zur Bauinspektion nach Anspruch 11, wobei der Schritt zum Abgleichen des Koordinatenpunkts des ersten Bauwerksmodells, um mit einem Koordinatenpunkt des zweiten Bauwerksmodells übereinzustimmen, wenn das erste Bauwerksmodell mit dem zweiten Bauwerksmodell verglichen wird, Folgendes einschließt
einen Schritt zum Angeben eines Begrenzungsrahmens des ersten Bauwerksmodells und eines Begrenzungsrahmens des zweiten Bauwerksmodells, und
einen Schritt zum Überlappen eines Mittelpunkts des Begrenzungsrahmens des ersten Bauwerksmodells mit einem Mittelpunkt des Begrenzungsrahmens des zweiten Bauwerksmodells.

13. Verfahren zur Bauinspektion nach Anspruch 1, wobei der Schritt zum Vergleichen des ersten Bauwerksmodells mit dem zuvor erstellten zweiten Bauwerksmodell basierend auf den Bauwerksgestaltungsdaten, um das Vergleichsergebnis zu erfassen, einen Schritt zum einzelnen Vergleichen von Informationen aller Komponenten im ersten Bauwerksmodell mit Informationen entsprechender Komponenten im zweiten Bauwerksmodell einschließt, um eine Komponente anzugeben, die eine mangelnde Übereinstimmung aufweist.

14. Verfahren zur Bauinspektion nach Anspruch 13, wobei die Informationen der Komponente mindestens entweder eine Position, einen Winkel, eine Modellnummer, eine Größe, einen Namen, eine Kennung, eine Farbe, eine Kategorie, eine Seriennummer, eine Marke, einen Werkstoff oder eine Oberflächenpräzision der Komponente einschließen.

15. Verfahren zur Bauinspektion nach Anspruch 13, ferner Folgendes umfassend:
einen Schritt zum Markieren der Komponente, die die mangelnde Übereinstimmung im zweiten Bauwerksmodell aufweist; und
einen Schritt zum Anzeigen des zweiten Bauwerksmodells, in dem die Komponente, die die mangelnde Übereinstimmung aufweist, markiert ist, durch eine Augmented-Reality-Vorrichtung.

16. Verfahren zur Bauinspektion nach Anspruch 13, wobei der Schritt zum Bestätigen des Inspektionsergebnisses des Bauwerks im Einklang mit dem Vergleichsergebnis Folgendes einschließt
einen Schritt zum Vergleichen der mangelnden Übereinstimmung mit einem Inspektionsstandard, und einen Schritt zum Generieren des Inspektionsergebnisses im Einklang mit dem Vergleichsergebnis.

17. Verfahren zur Bauinspektion nach Anspruch 1, ferner umfassend einen Schritt zum Anzeigen des Inspektionsergebnis durch eine Virtual-Reality-Vorrichtung.

18. Verfahren zur Bauinspektion nach Anspruch 1, ferner umfassend einen Schritt zum Aktualisieren des zweiten Bauwerksmodells im Einklang mit dem Inspektionsergebnis.

19. Einrichtung zur Bauinspektion, umfassend:
eine Modellierungseinheit, die ein erstes Bauwerksmodell basierend auf Erkennungsdaten an einer Baustelle erstellt;
eine Vergleichseinheit, die das erste Bauwerksmodell mit einem zuvor erstellten zweiten Bauwerksmodell basierend auf Bauwerksgestaltungsdaten vergleicht, um ein Vergleichsergebnis zu erfassen;
eine Bestätigungseinheit, die ein Inspektionsergebnis eines Bauwerks im Einklang mit dem Vergleichsergebnis bestätigt; und
eine Weitergabeeinheit, die das Inspektionsergebnis an einen Nutzer weitergibt,
wobei das erste Bauwerksmodell ein Scan-Modell einer Klimaanlage in einem realen Raum ist, das zweite Bauwerksmodell ein Bauwerksinformationsmodell, BIM-Modell, einer Klimaanlage ist,
die Vergleichseinheit ausgelegt ist, um eine Kollisionsprüfung zwischen dem ersten Bauwerksmodell und
dem zweiten Bauwerksmodell durchzuführen, um das Vergleichsergebnis zu erfassen, wenn ein nicht übereinstimmender Teil zwischen dem ersten Bauwerksmodell und dem zweiten Bauwerksmodell vorliegt,
wobei eine ID der entsprechenden Komponente im BIM-Modell und die Ursache für die fehlende Übereinstimmung aufgezeichnet werden.

20. System zur Bauinspektion, umfassend:
ein Endgerät, das Erkennungsdaten an einer Baustelle erfasst; und
die Einrichtung zur Bauinspektion nach Anspruch 19, die ein Inspektionsergebnis eines Bauwerks basierend auf den Erkennungsdaten an der Baustelle und einem zuvor erstellten zweiten Bauwerksmodell basierend auf Bauwerksgestaltungsdaten bestätigt.

## Revendications

1. Procédé d'inspection de construction mis en œuvre par ordinateur, comprenant :
une étape consistant à établir un premier modèle de construction basé sur les données de détection sur un chantier de construction ;
une étape consistant à comparer le premier modèle de construction avec un second modèle de construction précédemment établi basé sur les données de conception de construction pour acquérir un résultat de comparaison ;
une étape consistant à confirmer un résultat d'inspection d'une construction conformément au résultat de comparaison ; et
une étape consistant à partager le résultat d'inspection avec un utilisateur,
**caractérisé en ce que** le premier modèle de construction est un modèle balayé d'un climatiseur dans un espace réel, dans lequel le second modèle de construction est un modèle d'information de bâtiment, modèle BIM, d'un climatiseur,
l'étape consistant à comparer le premier modèle de construction avec le second modèle de construction précédemment établi sur la base des données de conception de construction pour acquérir le résultat de comparaison inclut une étape consistant à réaliser une vérification de collision entre le premier modèle de construction et
le second modèle de construction pour acquérir le résultat de comparaison, dans lequel lorsqu'il y a une partie incohérente entre le premier modèle de construction et le second modèle de construction, un ID du composant correspondant dans le modèle BIM et la cause de l'incohérence sont enregistrés.

2. Procédé d'inspection de construction selon la revendication 1, comprenant en outre une étape consistant à acquérir les données de détection, dans lequel l'étape consistant à acquérir les données de détection inclut
une étape consistant à balayer le chantier de construction par un capteur radar laser pour acquérir un signal radar laser renvoyé,
une étape consistant à capturer le chantier de construction par un dispositif d'imagerie pour acquérir un signal d'image, ou
une étape consistant à transmettre une onde électromagnétique haute fréquence au chantier de construction par un dispositif radar pénétrant dans le sol pour acquérir un signal d'onde électromagnétique renvoyé.

3. Procédé d'inspection de construction selon la revendication 2, dans lequel
le capteur radar laser est fourni dans un dispositif de réalité augmentée, et/ou
le dispositif d'imagerie est fourni dans un dispositif sans opérateur ou un robot.

4. Procédé d'inspection de construction selon la revendication 2, dans lequel l'étape consistant à établir le premier modèle de construction sur la base des données de détection sur le chantier de construction inclut
une étape consistant à générer des données de nuage de points tridimensionnels sur la base du signal radar laser renvoyé, et
une étape consistant à établir le premier modèle de construction basé sur les données de nuage de points tridimensionnel.

5. Procédé d'inspection de construction selon la revendication 2, dans lequel l'étape consistant à établir le premier modèle de construction sur la base des données de détection sur le chantier de construction inclut
une étape consistant à acquérir des données d'image capturées sous de multiples angles dans le signal d'image,
une étape consistant à traiter les données d'image capturées sous de multiples angles pour acquérir des données d'image omnidirectionnelles, et
une étape consistant à établir le premier modèle de construction basé sur les données d'image omnidirectionnelles.

6. Procédé d'inspection de construction selon la revendication 2, dans lequel l'étape consistant à établir le premier modèle de construction sur la base des données de détection sur le chantier de construction inclut
une étape consistant à extraire une caractéristique du signal d'onde électromagnétique renvoyé,
une étape consistant à spécifier des informations d'un composant sur le chantier de construction basé sur la caractéristique du signal d'onde électromagnétique renvoyé, et
une étape consistant à établir le premier modèle de construction basé sur les informations du composant sur le chantier de construction.

7. Procédé d'inspection de construction selon la revendication 1, comprenant en outre, avant de comparer le premier modèle de construction avec le second modèle de construction, une étape consistant à positionner le second modèle de construction sur le chantier de construction pour superposer le second modèle de construction sur une zone de construction et à afficher le second modèle de construction par un dispositif de réalité augmentée.

8. Procédé d'inspection de construction selon la revendication 7, comprenant en outre une étape consistant à afficher le premier modèle de construction et le résultat de comparaison par le dispositif de réalité augmentée.

9. Procédé d'inspection de construction selon la revendication 7, dans lequel l'étape consistant à positionner le second modèle de construction sur le chantier de construction inclut
une étape consistant à positionner avec deux points de localisation au niveau de la zone de construction,
une étape consistant à positionner avec un mur au niveau de la zone de construction, ou
une étape consistant à positionner par balayage un code bidimensionnel installé sur la zone de construction.

10. Procédé d'inspection de construction selon la revendication 1, comprenant en outre une étape consistant à faire correspondre un point de coordonnées du premier modèle de construction pour coïncider avec un point de coordonnées du second modèle de construction.

11. Procédé d'inspection de construction selon la revendication 10, dans lequel l'étape consistant à faire correspondre le point de coordonnées du premier modèle de construction pour coïncider avec le point de coordonnées du second modèle de construction inclut une étape consistant, avant d'établir le premier modèle de construction, à faire correspondre le point de coordonnées du premier modèle de construction avec le point de coordonnées du second modèle de construction, ou
une étape consistant à faire correspondre le point de coordonnées du premier modèle de construction pour coïncider avec le point de coordonnées du second modèle de construction lors de la comparaison du premier modèle de construction avec le second modèle de construction.

12. Procédé d'inspection de construction selon la revendication 11, dans lequel l'étape consistant à faire correspondre le point de coordonnées du premier modèle de construction pour coïncider avec le point de coordonnées du second modèle de construction lors de la comparaison du premier modèle de construction avec le second modèle de construction inclut
une étape consistant à spécifier un cadre de délimitation du premier modèle de construction et un cadre de délimitation du second modèle de construction, et
une étape consistant à chevaucher un point central de la boîte de délimitation du premier modèle de construction avec un point central de la boîte de délimitation du second modèle de construction.

13. Procédé d'inspection de construction selon la revendication 1, dans lequel l'étape consistant à comparer le premier modèle de construction avec le second modèle de construction précédemment établi basé sur les données de conception de construction pour acquérir le résultat de comparaison inclut une étape consistant à comparer des informations de tous les composants dans le premier modèle de construction avec les informations des composants correspondants dans le second modèle de construction un par un pour spécifier un composant ayant une discordance.

14. Procédé d'inspection de construction selon la revendication 13, dans lequel les informations du composant incluent au moins un élément parmi une position, un angle, un numéro de modèle, une taille, un nom, un identifiant, une couleur, une catégorie, un numéro de série, une marque, un matériau et une précision de surface du composant.

15. Procédé d'inspection de construction selon la revendication 13, comprenant en outre :
une étape consistant à marquer le composant présentant la discordance dans le second modèle de construction ; et
une étape consistant à afficher, par un dispositif de réalité augmentée, le second modèle de construction dans lequel le composant ayant la discordance est marqué.

16. Procédé d'inspection de construction selon la revendication 13, dans lequel l'étape consistant à confirmer le résultat d'inspection de la construction conformément au résultat de comparaison inclut
une étape consistant à comparer la discordance avec une norme d'inspection, et
une étape consistant à générer le résultat de l'inspection conformément au résultat de comparaison.

17. Procédé d'inspection de construction selon la revendication 1, comprenant en outre une étape consistant à afficher le résultat d'inspection par un dispositif de réalité virtuelle.

18. Procédé d'inspection de construction selon la revendication 1, comprenant en outre une étape consistant à mettre à jour le second modèle de construction en fonction du résultat de l'inspection.

19. Appareil d'inspection de construction, comprenant :
une unité de modélisation qui établit un premier modèle de construction basé sur des données de détection sur un chantier de construction ;
une unité de comparaison qui compare le premier modèle de construction avec un second modèle de construction précédemment établi basé sur des données de conception de construction pour acquérir un résultat de comparaison ;
une unité de confirmation qui confirme un résultat d'inspection d'une construction conformément au résultat de comparaison ; et
une unité de partage qui partage le résultat d'inspection avec un utilisateur,
dans lequel le premier modèle de construction est un modèle de balayage d'un climatiseur dans un espace réel, le second modèle de construction est un modèle d'information de bâtiment, un modèle BIM, d'un climatiseur,
l'unité de comparaison est configurée pour effectuer une vérification de collision entre le premier modèle de construction et le second modèle de construction pour acquérir le résultat de comparaison, lorsqu'il y a une partie incohérente entre le premier modèle de construction et le second modèle de construction, dans lequel un ID du composant correspondant dans le modèle BIM et la cause de l'incohérence sont enregistrés.

20. Système d'inspection de construction, comprenant :
un dispositif terminal qui acquiert des données de détection sur un chantier de construction ; et
l'appareil d'inspection de construction selon la revendication 19 qui confirme un résultat d'inspection d'une construction basé sur les données de détection sur le chantier de construction et un second modèle de construction précédemment établi basé sur des données de conception de construction.
